# EUROPEAN PATENT APPLICATION

(11) **EP 3 893 345 A1**
(43) Date of publication of application: **13.10.2021**
(21) Application number: 21163518.0
(22) Date of filing: 18.03.2021
(51) Int. Cl.: H02H 3/28, H02H 3/32, H02H 1/00

(54) **DIFFERENTIAL PROTECTION SCHEME**

(30) Priority: 10.04.2020 US 202063008075 P
(71) Applicant: Hamilton Sundstrand Corporation, Charlotte, NC 28217-4578 (US)
(72) Inventor: VANEVENHOVEN, Jordan K., Rockford, IL 61107 (US); SEAGREN, Robert L., Rockford, IL 61114 (US)
(74) Representative: Dehns

(57) **Abstract**

A system and method (300) for differential protection is provided. Aspects includes determining a first current value associated with a first current transformer (CTA) coupled to a first location in a differential protection zone, the first current transformer having a first transformer ratio, determining a second current value associated with a second current transformer (CTB) coupled to a second location in the differential protection zone, the second current transformer having a second transformer ratio, and determining, by a controller (102), a type of fault associated with the differential protection zone based on the first current value and the second current value.

## Description

### BACKGROUND

The subject matter disclosed herein generally relates to protection circuits and, more particularly, to a differential protection scheme.

Differential protection circuitry is often employed in power supply systems to sense and respond to adverse current fault conditions. The protection circuitry is positioned to protect a portion of the system referred to in the art as the differential protection zone and includes sensors that monitor the current flow at the first and second boundaries of the zone. An abnormal current condition within the zone, created, for example, by a short circuit, causes the current flow between the zone boundaries to differ. The sensors, in response to the sensed differential current, actuate means to mitigate the fault current condition. Such protection is especially advantageous where rapid response to fault current conditions is crucial. For example, early response to an abnormal current condition will often mitigate arcing or prevent wire fires which are particularly hazardous in locations near the combustible jet fuel tanks aboard an aircraft.

### BRIEF DESCRIPTION

According to one embodiment a method for differential protection is provided. The method includes determining a first current value associated with a first current transformer coupled to a first location in a differential protection zone, the first current transformer having a first transformer ratio, determining a second current value associated with a second current transformer coupled to a second location in the differential protection zone, the second current transformer having a second transformer ratio, and determining, by a controller, a type of fault associated with the differential protection zone based on the first current value and the second current value.

According to another embodiment, a system for differential protection is provided. The system includes a first current transformer having a first transformer ratio, a second current transformer having a second transformer ratio, a differential protection zone comprising at least one protection unit, and a controller configured to determine a first current value associated with the first current transformer, determine a second current value associated with the second current transformer, and determine a type of fault associated with the differential protection zone based on the first current value and the second current value.

The foregoing features and elements may be combined in various combinations without exclusivity, unless expressly indicated otherwise. These features and elements as well as the operation thereof will become more apparent in light of the following description and the accompanying drawings. It should be understood, however, that the following description and drawings are intended to be illustrative and explanatory in nature and non-limiting.

### BRIEF DESCRIPTION OF THE DRAWINGS

The foregoing and other features, and advantages of the present disclosure are apparent from the following detailed description taken in conjunction with the accompanying drawings in which:
FIG. 1 depicts a schematic block diagram of an electric power system having a differential protection scheme according to one or more embodiments;
FIG. 2 depicts a graph showing current magnitudes for differential faults, over current faults, and open phase faults with current transformers having different transformer ratios according to one or more embodiments; and
FIG. 3 is a flowchart of a method of differential protection in accordance with one or more embodiments of the present disclosure.

### DETAILED DESCRIPTION

As shown and described herein, various features of the disclosure will be presented. Various embodiments may have the same or similar features and thus the same or similar features may be labeled with the same reference numeral, but preceded by a different first number indicating the figure to which the feature is shown. Thus, for example, element "a" that is shown in FIG. X may be labeled "Xa" and a similar feature in FIG. Z may be labeled "Za." Although similar reference numbers may be used in a generic sense, various embodiments will be described and various features may include changes, alterations, modifications, etc. as will be appreciated by those of skill in the art, whether explicitly described or otherwise would be appreciated by those of skill in the art.

Embodiments described herein are directed to a differential protection scheme utilizing a pair of current transformers with different transformer ratios placed at different locations in a differential protection zone that allows for the determination of faults in an electric power system related to overcurrent conditions, open phase conditions, and differential faults.

Typical differential protection schemes utilize two sets of current transformers (CT) in series at different locations on a power transmission line in an electrical power system. A control unit can monitor current values that are sensed at each CT to determine whether a differential fault exists within a differential protection zone defined between the two CTs. During normal conditions in the typical differential protection scheme, each CT will sense the same current amount. However, if there is an electrical fault either downstream or upstream from the CTs, each CT in series will read the same amount of current and any system protections in place (e.g., circuit breakers, etc.) will be performed accordingly. However, if a fault were to occur between where the two sets of CTs are located (i.e., the differential protection zone), the two CTs would sense different current values at their respective locations. In this case, the differential protection scheme would initiate a protective trip using a protection device such as, for example, a contactor. This protective trip is initiated faster than a circuit breaker because it occurs within the protection zone and away from any loads on the system.

In some applications, the traditional differential protection scheme may not be feasible due to the limited availability of input/output (I/O) available on the control unit. In this case, a concession is made where the CTs of the same phase are connected differentially and fed through a single input in the control unit. This results in the current values sensed at each CT will cancel each other out and no current would be read at the input of the control unit. If a differential fault were to occur, a high current would flow through one CT and no current would flow through the other CT causing a high current value being read at the control unit and a protective measure would be initiated based on this current value being read at the control unit. Due to the limitations on I/O for control units in these typical differential protection schemes, protections related to over current and open phase conditions are not being detected.

To address this, aspects of the present disclosure provide for a differential protection scheme utilizing CTs with different transformer ratios that allows for detection of overcurrent and open phase conditions in addition to differential faults. In an electric power system, overcurrent or excess current is a situation where a larger than intended electric current exists through a conductor, leading to excessive generation of heat, and the risk of fire or damage to equipment. Possible causes for overcurrent include short circuits, excessive load, incorrect design, an arc fault, or a ground fault. Open phase condition or loss of a phase refers to one phase of three phases being physically and unintentionally disconnected on the primary side of the transformer. This could occur for several reasons such as a loose cable, a broken conductor, a blown fuse, a circuit breaker with one defective contact, and the like.

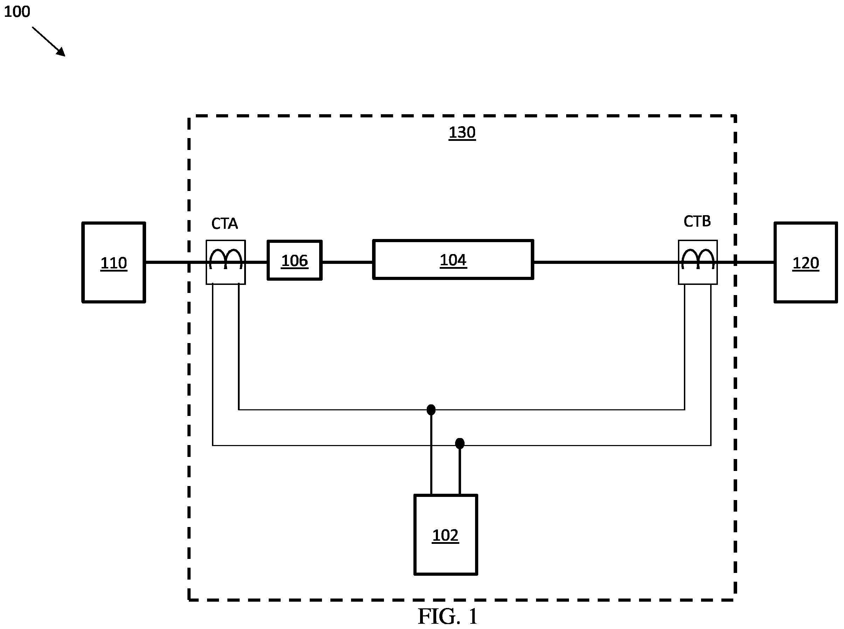

Turning now to the figures, FIG. 1 depicts a schematic block diagram of an electric power system having a differential protection scheme according to one or more embodiments. The electric power system 100 includes a source 110 and a load 120 with a differential protection scheme 130 there between. The differential protection scheme (zone) 130 includes a controller 102 (sometimes referred to as a "current monitor"), a first CT (CTA), a second CT (CTB), a differential protection object 104, and a protective device 106. In one or more embodiments, the differential protection object 104 can be a power transmission line such as a bus. In one or more embodiments, the differential protection scheme 130 protects the load 120 from over current and open phase conditions by utilizing CTs with different transformer ratios. The transformer ratio of CTA can be represented by X:1 and the transformer ratio of CTB can be represented by Y: 1. CTA is the current transformer closest to the source 110 and CTB is the current transformer closest to the load 120. In one embodiment, CTB can feature a lower transformer ratio than CTA (e.g., Y = X/2) so that for a given primary current, CTB will produce a higher secondary current than CTA. In some embodiments, Y < Xcan be chosen. With these transformer ratios, when there are normal conditions flowing through both CTA and CTB, these current values will be sensed by the controller 102 since there will be a difference in currents produced by CTA and CTB due to the differing transformer ratios. With the differential connection, the current read by the current monitor 102 (I_mon) can be shown as I_mon = I_CTA/X - I_CTB/Y. If X = Y, then when there is no fault in the DP zone, I mon will always be 0, even if there is an over current or open phase. However, if there is a fault in the DP zone, there will be no current through CTB, and so the current read by the monitor will be I mon = I_CTA/X - 0/Y = I_CTA/X = I_fault/X where I_fault is the fault current. So if X does not equal Y, for a normal current there should be an expected current value read by the monitor. In some embodiments, Y = X/2 is chosen. With this implementation, I_mon = I_CTA/X - I_CTB^{∗}2/X = (1/X)^{∗}(I_CTA - 2^{∗}I_CTB). When there are no faults, I_CTA = I_CTB, and so the current read by the monitor will be I_mon = -(1/X)^{∗}I_CTA. If there is a fault in the differential zone, I_CTB will be zero, and the monitor current will be I_mon = (1/X)^{∗}I_CTA. As can be seen, a fault in the differential zone will be accompanied by a change in polarity. So if a high current is read with no change in polarity, this can be determined to be an overcurrent fault outside the zone. If a high current is read with a change in polarity, this can be determined to be in the DP zone. If no current is read, this can be determined to be an open phase. When there is an over current condition outside the differential protection zone 130, this will correspond to a much higher current value sensed by the controller 102. When there is an open phase condition, this will correspond to no current sensed at the controller 102. And in the event of a differential fault (i.e., a fault between the two CTs), a high current will be sensed by the controller 102 from CTA but because there is no current through CTB and due to the differential connection of the CTs, this will result in a high current sensed with reverse polarity. This change in polarity can be used to isolate this fault from an overcurrent fault which would occur downstream from the two CTs (CTA, CTB). This change in polarity can be sensed using an external reference or detected via reference frame transformation techniques, for example. Thus, utilizing the different transformer ratios in CTA and CTB, over current, open phase, and differential faults can be detected when there is limited I/O for the controller 102.

In one or more embodiments, when a fault is detected, the controller 102 can operate the protection device 106 to engage an isolate the circuit until a repair can be made or the fault no longer exists.

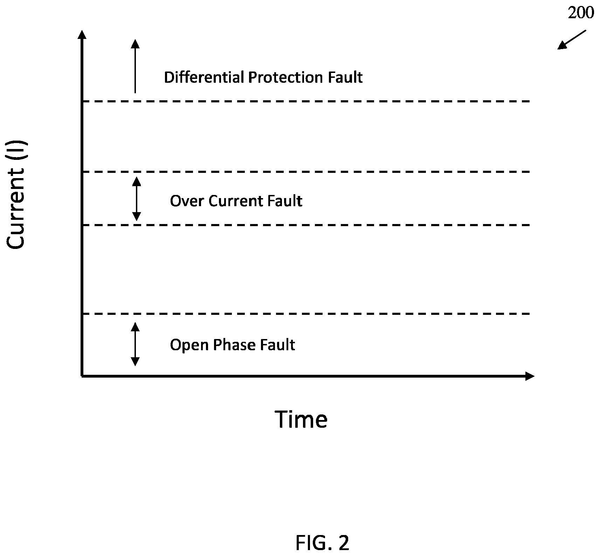

In one or more embodiments, when polarity cannot be sensed by the controller 102, the transformer ratio for CTA and CTB can be altered where CTB has a higher transformer ratio than CTA (e.g., Y = 2X) so that for a given primary current, CTB will produce a lower secondary current than CTA. Cases where polarity cannot be sensed include, but are not limited to, applications where instead of a direct analog sense of the AC signal by the controller 102, the currents are read though an AC RMS-DC converter. FIG. 2 depicts a graph showing current magnitudes for differential faults, over current faults, and open phase faults with current transformers having different transformer ratios according to one or more embodiments. The graph 200 depicts current magnitudes differences (I) between CTA and CTB over time. As shown in the graph 200, a higher current magnitude will be sensed during a differential fault for the same current that would be sensed during an overcurrent fault condition. In open phase conditions, the current sensed would be lower than the overcurrent fault condition. In some embodiments, Y = 2X is chosen. With this implementation, I_mon = I_CTA/X - 0.5^{∗}I_CTB/X = (1/X)^{∗}(I_CTA - 0.5^{∗}I_CTB). When there are no faults, I_CTA = I_CTB, and so the current read by the monitor 102 will be I mon = (1/X)^{∗}0.5^{∗}I_CTA. If there is a fault in the differential zone, I_CTB will be zero, and the monitor current will be I_mon = (1/X)^{∗}I_CTA. As can be seen, a fault in the differential zone will be result in a higher current read by the current monitor 102 than a fault current of similar magnitude outside of the DP zone. If no current is read, this can be determined to be an open phase. In one or more embodiments, Y > 2X can be chosen for the transformer ratio.

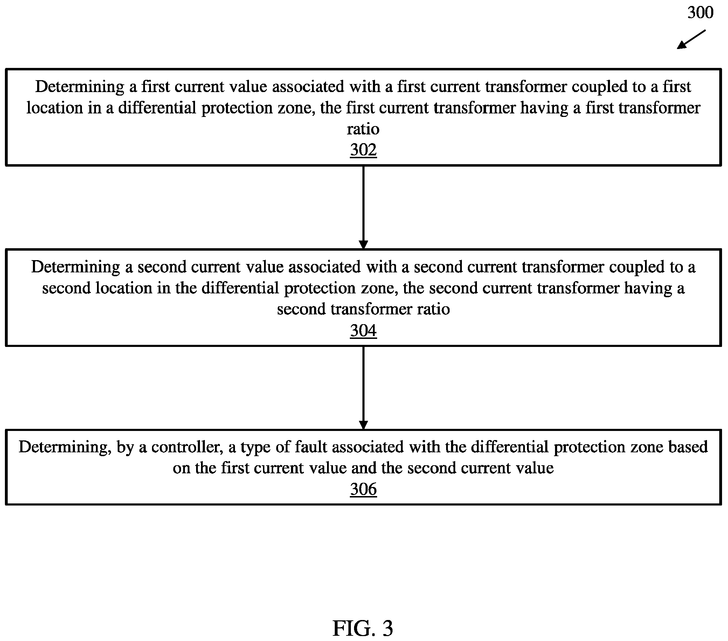

FIG. 3 is a flowchart of a method of differential protection in accordance with one or more embodiments of the present disclosure. The method includes determining a first current value associated with a first current transformer coupled to a first location in a differential protection zone, the first current transformer having a first transformer ratio, as shown in block 302. The method 300, at block 304, includes determining a second current value associated with a second current transformer coupled to a second location in the differential protection zone, the second current transformer having a second transformer ratio. The first transformer ratio and the second transformer ratio can be different from each other. For example, the second transformer ratio can be double the first transformer ratio. This could cause the first current transformer to sense a different current value at the first location than the second current transformer at the second location. Also, at block 306, the method 300 includes determining, by a controller, a type of fault associated with the differential protection zone based on the first current value and the second current value. This can be performed by determined what the expected current difference value is based on the first transformer ratio and second transformer ratio. When this expected current difference value is met, then the electrical system is operating under normal conditions. When there is variation from this expected current difference, then there are potential faults.

Additional processes may also be included. It should be understood that the processes depicted in FIG. 3 represent illustrations, and that other processes may be added or existing processes may be removed, modified, or rearranged without departing from the scope and spirit of the present disclosure.

In one or more embodiments, the controller 102 or any of the hardware referenced in the system 100 can be implemented by executable instructions and/or circuitry such as a processing circuit and memory. The processing circuit can be embodied in any type of central processing unit (CPU), including a microprocessor, a digital signal processor (DSP), a microcontroller, an application specific integrated circuit (ASIC), a field programmable gate array (FPGA), or the like. Also, in embodiments, the memory may include random access memory (RAM), read only memory (ROM), or other electronic, optical, magnetic, or any other computer readable medium onto which is stored data and algorithms as executable instructions in a non-transitory form.

While the present disclosure has been described in detail in connection with only a limited number of embodiments, it should be readily understood that the present disclosure is not limited to such disclosed embodiments. Rather, the present disclosure can be modified to incorporate any number of variations, alterations, substitutions, combinations, sub-combinations, or equivalent arrangements not heretofore described, but which are commensurate with the scope of the present disclosure. Additionally, while various embodiments of the present disclosure have been described, it is to be understood that aspects of the present disclosure may include only some of the described embodiments.

The terminology used herein is for the purpose of describing particular embodiments only and is not intended to be limiting. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

The corresponding structures, materials, acts, and equivalents of all means or step plus function elements in the claims below are intended to include any structure, material, or act for performing the function in combination with other claimed elements as specifically claimed. The description has been presented for purposes of illustration and description, but is not intended to be exhaustive or limited to the embodiments in the form disclosed. Many modifications and variations will be apparent to those of ordinary skill in the art without departing from the scope of the disclosure. The embodiments were chosen and described in order to best explain the principles of the disclosure and the practical application, and to enable others of ordinary skill in the art to understand various embodiments with various modifications as are suited to the particular use contemplated.

The present embodiments may be a system, a method, and/or a computer program product at any possible technical detail level of integration. The computer program product may include a computer readable storage medium (or media) having computer readable program instructions thereon for causing a processor to carry out aspects of the present disclosure.

Computer readable program instructions described herein can be downloaded to respective computing/processing devices from a computer readable storage medium or to an external computer or external storage device via a network, for example, the Internet, a local area network, a wide area network and/or a wireless network. The network may comprise copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device.

Aspects of the present invention are described herein with reference to flowchart illustrations and/or block diagrams of methods, apparatus (systems), and computer program products according to embodiments. It will be understood that each block of the flowchart illustrations and/or block diagrams, and combinations of blocks in the flowchart illustrations and/or block diagrams, can be implemented by computer readable program instructions.

The flowchart and block diagrams in the Figures illustrate the architecture, functionality, and operation of possible implementations of systems, methods, and computer program products according to various embodiments. In this regard, each block in the flowchart or block diagrams may represent a module, segment, or portion of instructions, which comprises one or more executable instructions for implementing the specified logical function(s). In some alternative implementations, the functions noted in the blocks may occur out of the order noted in the Figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

The descriptions of the various embodiments have been presented for purposes of illustration, but are not intended to be exhaustive or limited to the embodiments disclosed. Many modifications and variations will be apparent to those of ordinary skill in the art without departing from the scope of the described embodiments. The terminology used herein was chosen to best explain the principles of the embodiments, the practical application or technical improvement over technologies found in the marketplace, or to enable others of ordinary skill in the art to understand the embodiments disclosed herein.

Accordingly, the present disclosure is not to be seen as limited by the foregoing description, but is only limited by the scope of the appended claims.

## Claims

1. A method (300) for differential protection, the method comprising:
determining (302) a first current value associated with a first current transformer coupled to a first location in a differential protection zone, the first current transformer having a first transformer ratio;
determining (304) a second current value associated with a second current transformer coupled to a second location in the differential protection zone, the second current transformer having a second transformer ratio; and
determining, (306) by a controller (102), a type of fault associated with the differential protection zone based on the first current value and the second current value.

2. The method of Claim 1, wherein the first transformer ratio is greater than the second transformer ratio.

3. The method of Claim 1, wherein the first transformer ratio is less than the second transformer ratio.

4. The method of Claim 2, wherein determining, by the controller, the type of fault associated with the differential protection zone based on the first current value and the second value comprises:
determining an expected current difference value between the first current value and the second current value based on the first transformer ratio and the second transformer ratio; and
determining an overcurrent fault based on sensing, by the controller, a current value having a larger magnitude than the expected current difference value.

5. The method of Claim 2, or 4, wherein determining, by the controller, the type of fault associated with the differential protection zone based on the first current value and the second value comprises:
determining an expected current difference value between the first current value and the second current value based on the first transformer ratio and the second transformer ratio; and
determining an open phase fault based on sensing, by the controller, no current value.

6. The method of Claim 2, 4, or 5, wherein determining, by the controller, the type of fault associated with the differential protection zone based on the first current value and the second value comprises:
determining an expected current difference value between the first current value and the second current value based on the first transformer ratio and the second transformer ratio; and
determining a differential fault based on sensing, by the controller, a current value having an opposite polarity from the expected current difference value.

7. The method of Claim 3, wherein determining, by the controller, the type of fault associated with the differential protection zone based on the first current value and the second value comprises:
determining an expected current difference value between the first current value and the second current value based on the first transformer ratio and the second transformer ratio; and
determining an overcurrent fault based on sensing, by the controller, a current value within a predefined range of current values.

8. The method of Claim 3 or 7, wherein determining, by the controller, the type of fault associated with the differential protection zone based on the first current value and the second value comprises:
determining an expected current difference value between the first current value and the second current value based on the first transformer ratio and the second transformer ratio; and
determining an open phase fault based on sensing, by the controller, no current value.

9. The method of Claim 3, 7 or 8, wherein determining, by the controller, the type of fault associated with the differential protection zone based on the first current value and the second value comprises:
determining an expected current difference value between the first current value and the second current value based on the first transformer ratio and the second transformer ratio; and
determining a differential fault based on sensing, by the controller, a current value having a larger magnitude than the expected current difference value.

10. A system for differential protection, the system comprising:
a first current transformer (CTA) having a first transformer ratio;
a second current transformer (CTB) having a second transformer ratio;
a differential protection zone comprising at least one protection unit;
a controller (102) configured to:
determine a first current value associated with the first current transformer;
determine a second current value associated with the second current transformer; and
determine a type of fault associated with the differential protection zone based on the first current value and the second current value.

11. The system of Claim 10, wherein the first transformer ratio is greater than the second transformer ratio.

12. The system of Claim 10, wherein the first transformer ratio is less than the second transformer ratio.

13. The system of Claim 11, wherein determining, by the controller, the type of fault associated with the differential protection zone based on the first current value and the second value comprises:
determining an expected current difference value between the first current value and the second current value based on the first transformer ratio and the second transformer ratio; and:
determining an overcurrent fault based on sensing, by the controller, a current value having a larger magnitude than the expected current difference value; and/or determining an open phase fault based on sensing, by the controller, no current value; and/or determining a differential fault based on sensing, by the controller, a current value having an opposite polarity from the expected current difference value.

14. The system of Claim 12, wherein determining, by the controller, the type of fault associated with the differential protection zone based on the first current value and the second value comprises:
determining an expected current difference value between the first current value and the second current value based on the first transformer ratio and the second transformer ratio; and:
determining an overcurrent fault based on sensing, by the controller, a current value within a predefined range of current values; and/or determining an open phase fault based on sensing, by the controller, no current value; and/or determining a differential fault based on sensing, by the controller, a current value having a larger magnitude than the expected current difference value.

15. The method of any of claims 1-9 or the system of any of claims 10 to 14, wherein the second location is closer to a load (120) than the first location.
